# FASCICULE DE BREVET EUROPEEN

(11) **EP 0 961 313 B1**
(45) Date de publication et mention de la délivrance du brevet: **28.04.2004**
(21) Numéro de dépôt: 99401201.1
(22) Date de dépôt: 18.05.1999
(51) Int. Cl.: H01L 21/22, H01L 21/74

(54) **Procédé de dépôt par épitaxie d'une couche de silicium sur un substrat de silicium fortement dopé**
Verfahren zur epitaktischen Abscheidung von einer Siliziumschicht auf einem stark dotierten Siliziumsubstrat
Epitaxial deposition of a silicon layer on a heavily doped silicon substrate

(30) Priorité: 19.05.1998 FR 9806574
(43) Date de publication de la demande: 01.12.1999
(73) Titulaire: STMicroelectronics S.A., 92120 Montrouge (FR); FRANCE TELECOM, 75015 Paris (FR)
(72) Inventeur: Dutartre, Didier, 83000 Toulon (FR); Jerier, Patrick, 83000 Toulon (FR)
(74) Mandataire: Bentz, Jean-Paul

(56) Documents cités:
- US-A- 5 137 838
- PATENT ABSTRACTS OF JAPAN vol. 098, no. 003, 27 février 1998 (1998-02-27) -& JP 09 306844 A (SONY CORP), 28 novembre 1997 (1997-11-28) -& DATABASE WPI Derwent Publications Ltd., London, GB; AN 98-069125 XP002091272 & JP 09 306844 A
- PATENT ABSTRACTS OF JAPAN vol. 016, no. 166 (E-1193), 22 avril 1992 (1992-04-22) -& JP 04 014815 A (TOYOTA AUTOM LOOM WORKS LTD), 20 janvier 1992 (1992-01-20)
- C. YGARTUA ET AL: "Reduction of autodoping from Arsenic buried layers" EXTENDED ABSTRACTS., vol. 86-2, octobre 1986 (1986-10), pages 832-833, XP002091270 PRINCETON, NEW JERSEY US
- SCHMIDT D N: "Investigation of various substrate dopants and epitaxial growth techniques for producing sharp transition epitaxial wafers" JOURNAL OF THE ELECTROCHEMICAL SOCIETY, NOV. 1987, USA, vol. 134, no. 11, pages 2845-2850, XP002091271 ISSN 0013-4651

## Description

La présente invention concerne le domaine de la fabrication des circuits intégrés et plus particulièrement le dépôt d'une couche de silicium par épitaxie sur un substrat de silicium monocristallin comprenant des zones fortement dopées.

De façon générale, le dépôt par épitaxie en phase gazeuse d'une couche de silicium sur un substrat de silicium est une technique classique bien connue de l'homme de l'art, permettant d'obtenir des couches minces monocristallines dont le niveau de dopage est constant sur leur épaisseur. Cette technique est bien maîtrisée quand le dopage du substrat de silicium sur lequel on fait croître la couche épitaxiale est homogène et relativement faible.

Avec l'apparition de technologies plus récentes comme la technologie BICMOS, qui consiste à intégrer sur un même substrat des transistors bipolaires et des transistors NMOS et PMOS, on a toutefois été conduit à réaliser des couches enterrées par épitaxie de silicium sur un substrat comprenant des zones fortement dopées par implantation de dopants comme le bore (dopage de type P⁺), l'arsenic ou le phosphore (dopage de type N⁺). Ces couches enterrées réalisées par épitaxie sont par exemple destinées à former les collecteurs des transistors bipolaires des circuits BICMOS.

Il en résulte un phénomène connu, appelé autodopage, selon lequel le dopant implanté à forte dose dans le substrat tend à exodiffuser du substrat et s'incorporer dans la couche épitaxiée en modifiant ses propriétés électriques, notamment sa conductivité. Ce phénomène parasite de dopage non intentionnel entraîne une dispersion importante des caractéristiques électriques des circuits intégrés qu'il est difficile de maîtriser, car l'autodopage dépend de divers paramètres comme la pression et la température de travail dans le réacteur d'épitaxie, la surface des zones dopées du substrat de silicium se trouvant sous la couche épitaxiée, etc..

De plus, l'autodopage d'une couche de silicium épitaxiée se produit essentiellement pendant la phase initiale de croissance de la couche épitaxiée et est d'autant plus marqué que celle-ci est mince. Or, avec l'évolution de la technologie, on réalise des couches épitaxiées de plus en plus minces, de sorte que le phénomène d'autodopage devient de plus en plus problématique.

Enfin, l'autodopage par le bore, d'une part, et l'autodopage par l'arsenic ou le phosphore, d'autre part, obéissent à des lois inverses relativement à la pression et à la température de travail dans le réacteur d'épitaxie. Ainsi, une augmentation de la température ou une baisse de la pression dans le réacteur d'épitaxie permet de diminuer l'autodopage par l'arsenic (ou le phosphore) mais a pour effet inverse d'augmenter l'autodopage par le bore. Comme conséquence, il est impossible de diminuer simultanément les deux types d'autodopage lorsqu'une couche de silicium est épitaxiée sur un substrat comprenant à la fois des zones fortement dopées au bore (zones P⁺) et des zones fortement dopées à l'arsenic ou au phosphore (zones N⁺), comme c'est généralement le cas en pratique.

Dans l'art antérieur, il est d'usage de faire un compromis en choisissant une température et une pression de travail qui ne favorisent pas l'autodopage du premier type au regard de l'autodopage du second type. D'autres solutions ont été proposées, comme diminuer la vitesse de croissance épitaxiale, mais de façon générale aucune des solutions connues ne pallie de façon satisfaisante le problème de l'autodopage des couches épitaxiales.

Le document US-5,137,838 décrit ainsi un procédé de fabrication de dispositifs semi-conducteurs PNP comportant des couches enterrées fortement dopées de type P++, obtenues par implantation ionique de Bore et de Gallium, dans lequel il est prévu d'effectuer conjointement une implantation ionique de Germanium au sein-même de la couche enterrée, en profondeur à l'intérieur du substrat.

Le Germanium est implanté à une forte dose de 2.10¹⁶ atomes/cm² avec une énergie élevée d'accélération ionique de 180 keV pour s'implanter en profondeur sous la surface du substrat au niveau des atomes dopants de Bore qui forment la couche enterrée dopée de type P++.

La combinaison des impuretés de Germanium, de Bore, plus de Gallium inhibe la diffusion du Bore, ce qui permet de limiter l'extension et le surépaississement de la couche enterrée, dû à la forte diffusivité du Bore, au cours des étapes ultérieures de recuit et de croissance épitaxiale d'une couche supérieure de silicium prévu selon ce procédé de fabrication.

Le document US-5,137,838 énonce que ce procédé permet de réduire la diffusion et l'extension du dopage au Bore des couches enterrées de type P++ d'un dispositif PNP à un niveau comparable à la faible vitesse de diffusion des dopants de type N, comme l'Arsenic, des couches enterrées de type N++ d'un dispositif NPN, si bien que les performances des transistors PNP et NPN deviennent comparables.

Par contre, le document US-5,137,838 ne propose aucun moyen pour résoudre le problème de l'autodopage par l'Arsenic ou le Phosphore, lors de la croissance épitaxiale d'une couche de silicium épitaxiée sur un substrat de silicium comprenant une couche enterrée dopée de type N+ à l'Arsenic ou au Phosphore.

Un article de C. YGARTUA, et R. SMAROG, intitulé "*Reduction of Autodoping from Arsenic Buried Layers*" fait état de ce problème et propose deux méthodes pour réduire l'autodopage par l'Arsenic, consistant à effectuer un recuit étendu durant 16 minutes à 1200 °C et à déposer une couche-barrière "in-situ" d'une épaisseur considérable de 1000 nm que l'on fait croître à la surface du substrat suivi d'une purge d'hydrogène avant d'effectuer le reste de la croissance épitaxiale, ces deux méthodes pouvant se combiner.

Ces deux méthodes conventionnelles ne fournissent pas des résultats très satisfaisants, même combinés, la conductivité de la couche épitaxiale étant au mieux ramenée de 2985 µΩ⁻¹.m à 2057 µΩ⁻ ¹.m, soit une diminution de 31%.

Un autre article de D. N. Schmidt intitulé "Investigation of Various Substrate Dopants and Epitaxial Growth Techniques for Producing Sharp Transition Epitaxial Wafers" rapporte et compare des résultats de croissance épitaxiale d'une couche de silicium épitaxié sur des substrats de silicium dopés avec divers dopants, notamment l'arsenic, le phosphore et le bore.

L'article de D. N. Schmidt propose seulement de faire varier les conditions d'épitaxie, en modifiant uniquement la température et la vitesse de la croissance épitaxiale d'une couche de silicium épitaxie sur un substrat de silicium dopé par ces impuretés.

Les résultats expérimentaux dont D. N. Schmidt fait état présentent des différences peu sensibles, la modification de la résistivité de la couche de silicium épitaxiée sur un substrat dopé au phosphore provoquée par la modification des conditions d'épitaxie, restant cantonnée à une octave, c'est à dire inférieure à un facteur deux.

Ainsi, la présente invention a pour objectif de prévoir un moyen permettant de limiter l'autodopage par l'arsenic ou le phosphore d'une couche de silicium épitaxiée sur un substrat de silicium monocristallin comprenant des zones à forte concentration d'arsenic ou de phosphore.

Un autre objectif de la présente invention est de limiter l'autodopage par l'arsenic ou le phosphore d'une couche épitaxiée sans augmenter l'autodopage par le bore.

Ces objectifs sont atteints par la prévision d'un procédé selon la revendication 1.

Selon un mode de réalisation, l'étape de désorption des atomes superficiels d'arsenic ou de phosphore est faite en présence d'un balayage de la surface du substrat par un gaz d'hydrogène.

Selon un mode de réalisation, le débit de gaz d'hydrogène est augmenté par rapport aux conditions usuelles au moins pendant une période d'exposition du germanium au gaz d'hydrogène, afin de favoriser l'élimination des atomes superficiels d'arsenic ou de phosphore.

Selon un mode de réalisation, la faible dose de germanium est déposée au cours d'une étape de recuit précédant le dépôt par épitaxie de la couche de silicium.

Selon un mode de réalisation, la faible dose de germanium est déposée au cours d'une première étape de dépôt de silicium par épitaxie, en introduisant un composé gazeux du germanium dans la phase gazeuse d'épitaxie pour former un alliage germanium/silicium.

Selon un mode de réalisation, la première étape de dépôt de silicium est une étape d'épitaxie faite avec une vitesse de croissance du silicium choisie de manière à permettre la désorption des atomes superficiels d'arsenic ou de phosphore parallèlement à la croissance du silicium.

Selon un mode de réalisation, la première étape de dépôt de silicium est une étape de dépôt d'une couche mince de silicium, suivie d'une deuxième étape de dépôt d'une couche complémentaire de silicium.

Selon un mode de réalisation, le dépôt de la faible dose de germanium est effectué à une température de l'ordre de 1100°C et le dépôt de la couche de silicium est effectué essentiellement à une température de l'ordre de 1050°C.

La procédé peut être également décomposé en une première étape de dépôt d'une couche mince de silicium, une étape de recuit, et une deuxième étape de dépôt d'une couche complémentaire de silicium permettant d'obtenir l'épaisseur recherchée de la couche de silicium épitaxiée.

Avantageusement, les conditions et la durée de la première étape et du recuit sont choisies de manière que la couche mince de silicium forme une barrière à la diffusion d'atomes d'arsenic ou de phosphore dans la couche complémentaire de silicium.

Selon un mode de réalisation, la faible dose de germanium est déposée avant la première étape de dépôt de silicium, ou entre la première et la deuxième étape de dépôt de silicium.

Selon un mode de réalisation, la faible dose de germanium est déposée au cours de la première étape de dépôt de silicium, en introduisant un composé gazeux du germanium dans la phase gazeuse d'épitaxie pour former un alliage germanium/silicium.

Selon un mode de réalisation, on introduit dans la phase gazeuse d'épitaxie un composé dopant pour obtenir un dopage volontaire de la couche de silicium épitaxiée supérieur à la valeur d'autodapage.

Ces objets, caractéristiques et avantages ainsi que d'autres de la présente invention seront exposés plus en détail dans la description suivante du procédé de l'invention et de diverses variantes de ce procédé, faite à titre non limitatif en relation avec les figures jointes parmi lesquelles :
- les figures 1 et 2 illustrent schématiquement un procédé d'épitaxie sur un substrat de silicium comprenant des couches enterrées,
- la figure 3 illustre un procédé d'épitaxie selon l'art antérieur,
- la figure 4 illustre un mode de réalisation d'un procédé d'épitaxie selon la présente invention,
- la figure 5 est une vue de dessus d'une plaquette de test,
- la figure 6 illustre les résultats comparés d'autodopage à l'arsenic dans des couches épitaxiées formées selon un procédé classique et selon le procédé de l'invention,
- les figures 7A et 7B illustrent schématiquement un mécanisme possible d'autodopage par l'arsenic ou le bore dans un procédé d'épitaxie selon l'art antérieur,
- les figures 8A et 8B illustrent schématiquement une explication possible de la réduction de l'autodopage par le procédé selon l'invention, et
- la figure 9 illustre un autre mode de réalisation d'un procédé d'épitaxie selon la présente invention.

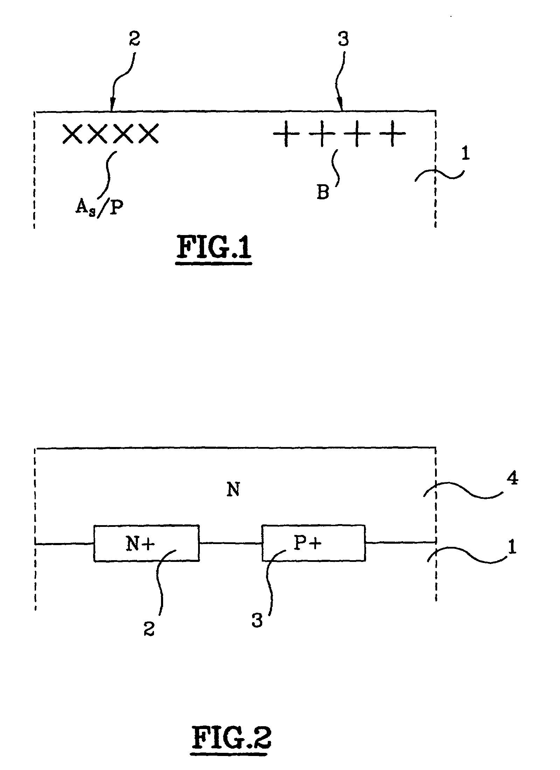

Les figures 1 et 2 illustrent un procédé classique permettant de réaliser une couche épitaxiée sur un substrat de silicium monocristallin 1 comprenant des zones dopées 2, 3 de type N⁺ et P⁺. Comme représenté en figure 1, on commence par former les zones dopées 2, 3 par implantation à forte dose de dopants, par exemple de l'arsenic ou du phosphore pour les zones N+ et du bore pour les zones P+. Ensuite, comme représenté en figure 2, on fait croître par épitaxie à la surface du substrat 1 une couche de silicium monocristallin 4, de sorte que les zones dopées 2, 3 deviennent des couches enterrées recouvertes par la couche épitaxiée 4.

La croissance épitaxiale s'effectue en phase gazeuse avec une pression et une température déterminées, en présence d'hydrogène et d'un composé du silicium tel que le dichlorosilane (SiHCl₂) ou le trichlorosilane (SiHCl₃) et en présence d'un composé dopant, par exemple de la phosphine (PH3) ou de l'arsine (AsH3), pour former une couche épitaxiée 4 de type N.

Comme on l'a exposé au préambule, le dopage de la couche épitaxiée 4 est influencé par des exodiffusions d'arsenic ou de phosphore, et de bore, en provenance des couches enterrées 2,3, et leur incorporation incontrôlée dans la couche épitaxiée.

Pour pallier cet inconvénient, la présente invention se base sur une constatation faite par la demanderesse selon laquelle le dépôt d'une faible dose de germanium avant le dépôt de la couche épitaxiée 4, suivi de préférence d'un temps de repos avec pompage et/ou balayage d'hydrogène dans le réacteur d'épitaxie, diminue de façon notable et avantageuse l'autodopage par l'arsenic ou le phosphore. De façon très schématique, et sous toutes réserves, la demanderesse attribue ce résultat avantageux au fait que la présence du germanium favorise l'élimination d'atomes d'arsenic ou de phosphore se trouvant à la surface du substrat, responsables en grande partie de l'autodopage de la couche épitaxiée.

Avant de donner une explication plus précise de ce mécanisme d'élimination des atomes superficiels d'arsenic ou de phosphore, qui ne constituera en tout état de cause qu'une hypothèse avancée par la demanderesse pour expliquer les avantages de la découverte selon l'invention, on va tout d'abord décrire, pour fixer les idées, un exemple de mise en oeuvre de l'invention.

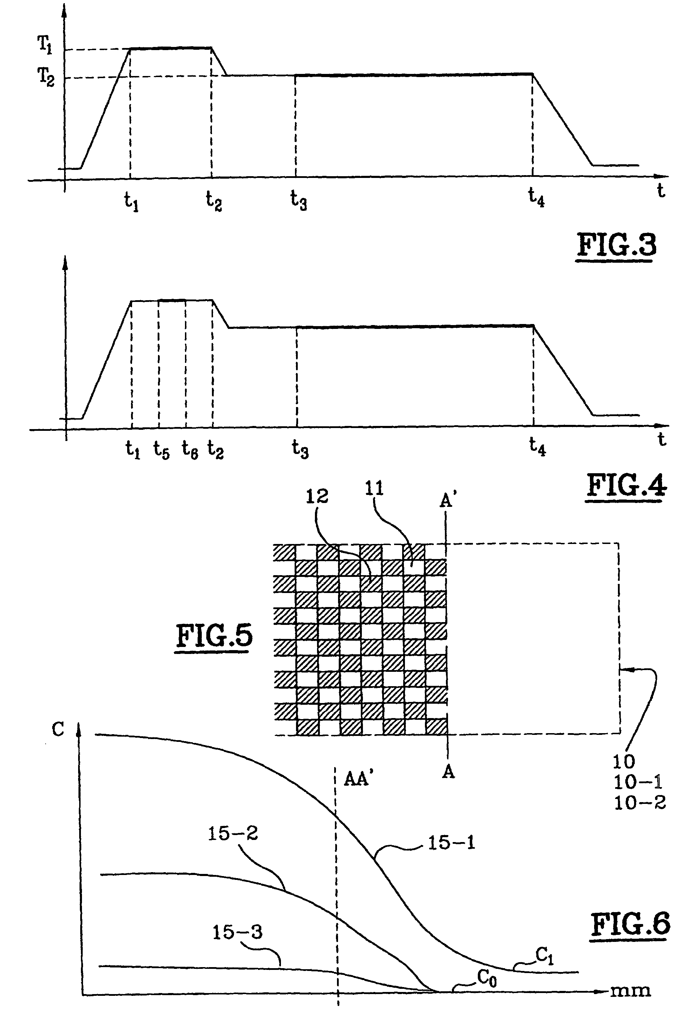

La figure 3 illustre un procédé d'épitaxie classique à deux paliers de températures T1, T2 auquel on va appliquer l'invention. Classiquement, le premier palier de température T1 est atteint à un instant t1 après une période initiale de montée en température du réacteur d'épitaxie. La température T1, par exemple 1100°C, est généralement choisie plus élevée que la température d'épitaxie T2 et est maintenue jusqu'à un instant t2 en présence d'hydrogène à basse pression, par exemple 60 torrs (environ 10⁴ Pa). Cette phase préliminaire dite de recuit se termine à un instant t2, où l'on commence à descendre à la température T2 choisie pour le dépôt épitaxial, par exemple 1050°C. On procède à la croissance épitaxiale proprement dite à un instant t3, lorsque la température est stabilisée, en présence d'hydrogène, d'un composé de croissance du silicium comme du dichlorosilane et d'un composé dopant comme de la phosphine ou de l'arsine. L'épitaxie est arrêtée à un instant t4 lorsque l'épaisseur souhaitée de la couche de silicium épitaxiée est atteinte, et on termine le processus en diminuant progressivement la température selon un profil déterminé, ces diverses étapes étant bien connues de l'homme de l'art.

Selon l'invention, comme représenté en figure 4, on propose d'introduire dans la phase gazeuse un composé du germanium comme du gaz GeH4, par exemple entre un instant t5 et un instant t6 de la période de recuit, puis d'attendre un laps de temps t6-t2 avant de redescendre à la température T1. Le temps t5-t6 d'introduction du composé GeH4, de l'ordre de la dizaine de secondes à quelques dizaines de secondes, est choisi de manière que la couche de germanium déposée à la surface du substrat de silicium soit de l'ordre de la fraction de monocouche atomique (en tenant compte de la diffusion partielle du germanium dans le substrat) à quelques couches atomiques. Le temps t6-t2 de balayage d'hydrogène à la température T1 après dépôt du germanium est de quelques secondes à quelques dizaines de secondes, par exemple 30 secondes.

L'effet avantageux d'un tel dépôt de germanium sur le phénomène d'autodopage de la couche de silicium épitaxiée entre les instants t3 et t4 est mis en évidence au moyen d'une plaquette de test 10 du type représenté en figure 5. La plaquette 10 comprend à gauche d'un axe AA' une zone implantée ayant l'aspect d'un damier, comprenant une alternance de régions ou "cases" 11 implantées à l'arsenic et de cases 12 non implantées (cases hachurées), les cases étant par exemple d'une dimension de 10 x 10 mm. A droite de l'axe AA' se trouve une zone non implantée. Plus particulièrement, on procède à un essai comparatif en déposant sur une première plaquette de test 10-1 une couche de silicium non dopée épitaxiée selon le procédé de l'art antérieur, et sur une deuxième plaquette de test 10-2 une couche de silicium non dopée épitaxiée selon le procédé de l'invention, c'est-à-dire avec dépôt de germanium en t5-t6, pompage et/ou balayage d'hydrogène en t6-t2. On compare ensuite la conductivité C, mesurée en µΩ⁻¹, des deux couches épitaxiées.

La figure 6 représente les courbes 15-1, 15-2 de la conductivité des deux couches épitaxiées, mesurée dans les cases 12 non implantées en parcourant les plaquettes de test 10-1, 10-2 de la gauche vers la droite. La courbe 15-1 met en évidence l'inconvénient du procédé de l'art antérieur et montre que la conductivité est très forte au dessus de la zone implantée (autodopage de type N) , à gauche de l'axe AA', et va en diminuant dans la zone non implantée, à droite de l'axe AA', pour atteindre une valeur limite C1 sensiblement supérieure à la valeur nominale C0 de conductivité que devrait présenter la couche épitaxiée. Par contre, la courbe 15-2 montre clairement que le procédé selon l'invention permet de diminuer très sensiblement l'autodopage par l'arsenic, l'augmentation de conductivité au dessus de la zone implantée étant atténuée dans une proportion d'environ 50%. De plus, la conductivité tend vers la valeur nominale C0 dans la zone non implantée de la plaquette de test.

Des mesures similaires de conductivité avec une implantation au phosphore des régions 11 d'une plaquette de test ont montré des avantages équivalents du procédé de l'invention. Par ailleurs, des mesures similaires avec une implantation au bore (dopage de type P⁺) des régions 11 n'ont pas montré de différence nette entre le procédé de l'art antérieur et le procédé selon l'invention. Ainsi, la présente invention permet de diminuer l'autodopage par l'arsenic ou le phosphore sans empirer l'autodopage par le bore. On verra plus loin comment on peut, en pratique, tirer profit de ces résultats.

On va maintenant donner une explication plus détaillée des phénomènes qui conduisent à ces résultats, de l'avis actuel des inventeurs. Il va de soi que, même s'il s'avère que cette explication théorique est erronée ou incomplète, ceci ne saurait affecter la portée de l'invention dont les résultats ont été démontrés.

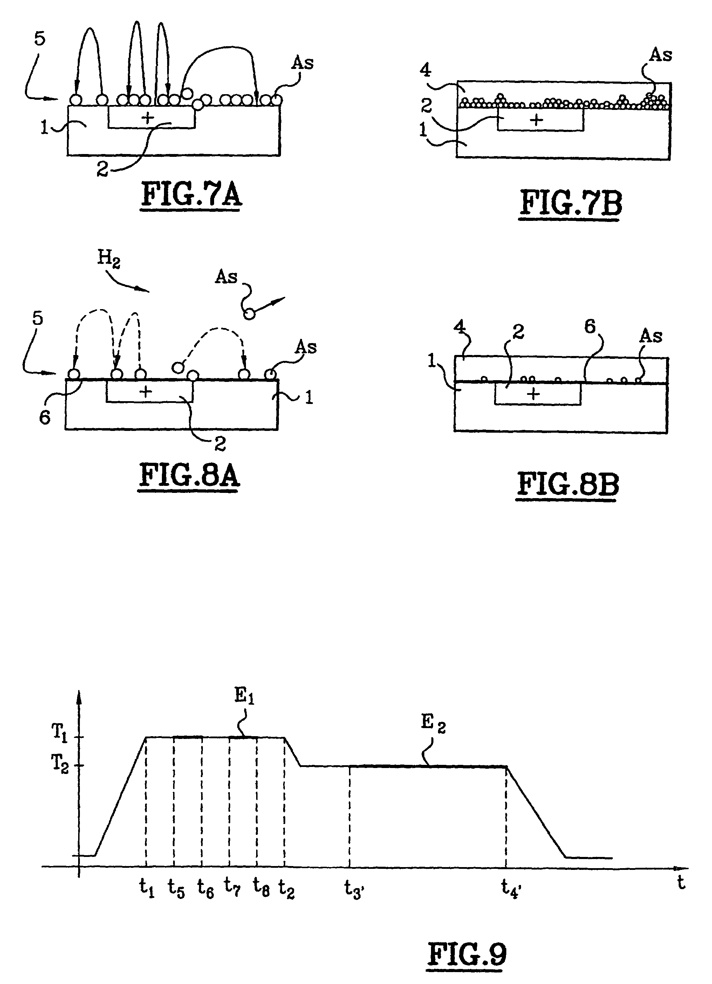

La figure 7A représente schématiquement un substrat 1 comprenant une zone enterrée 2 dans laquelle on a implanté des atomes d'arsenic. La demanderesse considère qu'il existe à la surface du substrat des atomes d'arsenic formant une couche 5 très mince sensiblement monoatomique. Au cours de l'épitaxie, cette couche superficielle 5 demeure à la surface du substrat 1 et constitue en permanence une source de dopage de la couche de silicium en cours de croissance, par mécanismes de ségrégation et d' incorporation. Ainsi, comme le montre schématiquement la figure 7B, la couche épitaxiée 4 comprend dans son épaisseur des atomes d'arsenic et présente un profil de dopage à l'arsenic décroissant en allant de l'interface du substrat 1 et de la couche épitaxiée 4 vers la surface.

Par contre, comme représenté en figure 8A, le dépôt d'une faible dose de germanium 6 à la surface du substrat a pour effet de créer des sites atomiques où des atomes d'arsenic se trouvent liés à des atomes du germanium, qui remplacent en tout ou en partie des sites atomiques où des atomes d'arsenic se trouvent liés à des atomes de silicium. Les liaisons AsGe étant d'une énergie plus faible que les liaisons AsSi, les atomes d'arsenic des sites de germanium ont une tendance à la désorption plus marquée que les atomes d'arsenic des sites de silicium et sont évacués par le pompage et/ou le balayage d'hydrogène sous forme d'atomes As ou de molécules As2, et/ou de composés AsH, AsH2, AsH3, selon les conditions de température et de pression. Les atomes d'arsenic liés aux atomes de germanium sont par conséquent éliminés avec une efficacité bien plus grande que dans l'art antérieur. En résumé, le germanium crée des sites atomiques favorisant l'élimination des atomes d'arsenic et le "nettoyage" de la couche superficielle d'arsenic 5.

Ainsi, comme le montre la figure 8B, le nombre d'atomes d'arsenic se retrouvant ensuite dans la couche épitaxiée 4 est considérablement réduit. Compte tenu des résultats expérimentaux décrits plus haut, ces explications s'appliquent aux atomes de phosphore et ne semblent pas s'appliquer aux atomes de bore, pour des raisons qui apparaîtront clairement à l'homme de l'art, tenant aux propriétés physico-chimiques de ces divers éléments.

En pratique, il est clair que les résultats de l'invention dépendent en partie de paramètres comme le débit et la pression d'hydrogène dans le réacteur d'épitaxie, la vitesse de pompage.... Dans les essais ayant conduit aux résultats exposés plus haut, la demanderesse a choisi de conserver les valeurs habituelles de débit et de pression d'hydrogène. Il est toutefois à la portée de l'homme de l'art de tester et choisir de nouveaux paramètres favorisant l'élimination des atomes superficiels d'arsenic ou de phosphore. Notamment, la vitesse de pompage (cas d'un processus sous vide) et/ou le débit de gaz d'hydrogène (cas d'un processus en présence d'hydrogène) peuvent être augmentés par rapport aux conditions usuelles, au moins pendant une courte période.

Il apparaîtra également à l'homme de l'art que la présente invention est susceptible de nombreuses variantes et modes de réalisations, notamment en ce qui concerne la dose de germanium déposée sur le substrat, la durée de la période t5-t6 de dépôt du germanium et la durée de la période d'élimination des atomes superficiels d'arsenic ou de phosphore. Dans le procédé représenté en figure 4, on estime que l'élimination des atomes d'arsenic ou de phosphore se produit essentiellement pendant la période t6-t2 plutôt que la période t2-t3, dans la mesure où la température de recuit T1 est supérieure à la température d'épitaxie T2. Toutefois, étant donné que les températures T1 et T2 et la pression de travail ont été choisis dans l'art antérieur pour obtenir un compromis entre l'autodopage par l'arsenic ou le phosphore et l'autodopage par le bore, comme on l'a expliqué au préambule, il est clair que les avantages de la présente invention permettent de choisir de nouveaux paramètres de travail définissant un nouveau compromis. Ainsi, en pratique, l'invention permet non seulement la diminution de l'autodopage par l'arsenic ou le phosphore, mais également de diminuer l'autodopage par le bore.

Encore une autre variante de la présente invention consiste à procéder au dépôt de germanium au commencement du processus d'épitaxie proprement dit, c'est-à-dire à l'instant t3 sur la figure 4, par exemple en introduisant pendant quelques dizaines de secondes le composé GeH4 dans la phase gazeuse d'épitaxie. On obtient alors un alliage SiGe qui forme une couche de base dans le silicium épitaxié, les pressions partielles de gaz étant choisies de manière que l'alliage SiGe contiennent de préférence une proportion de germanium de l'ordre de 1 à 10 %. L'épitaxie étant un phénomène assez lent, ce mode de réalisation permet comme le précédent de bénéficier du mécanisme d'élimination des atomes superficiels d'arsenic ou de phosphore par brisement des liaisons atomiques avec le germanium. Ainsi, on voit que l'étape d'élimination des atomes superficiels est ici concomitante à l'étape de dépôt du germanium, alors que cette étape était subséquente à l'étape de dépôt dans le mode de réalisation précédent.

Dans le cas présent, la vitesse de croissance du silicium est de préférence choisie de manière à permettre la désorption des atomes superficiels d'arsenic ou de phosphore parallèlement à la croissance du silicium. Par exemple, on choisit une vitesse de croissance assez lente pendant la phase d'introduction du germanium, par exemple de l'ordre de 1000 angströms par minute pendant une demi minute. Puis, si cela est souhaité, on augmente la vitesse de croissance, en la portant par exemple à 1 micromètre par minute.

Par ailleurs, il est bien évident que le germanium déposé à la surface du substrat est susceptible d'être retiré ultérieurement, par exemple par gravure au moyen d'un gaz d'acide chlorhydrique (HCl). Ainsi, en pratique, l'étape classique de gravure de la couche de silicium épitaxiée, permettant par exemple de faire apparaître des collecteurs de transistors bipolaires, pourra être suivie d'une étape de suppression du germanium présent à la surface des zones gravées.

Dans ce qui précède, on a vu que le procédé de l'invention permet de diminuer sensiblement l'autodopage d'une couche de silicium épitaxiée, sans toutefois le supprimer entièrement. De plus, le choix d'un compromis permettant de diminuer également l'autodopage par le bore va conduire en pratique à renforcer l'autodopage par l'arsenic ou le phosphore au regard des meilleurs résultats que peut offrir l'invention.

Dans ces conditions, la présente invention propose de combiner les avantages d'un dépôt de germanium avec les avantages d'un procédé d'épitaxie en deux étapes E1, E2 illustré sur la figure 9. La première étape d'épitaxie E1, de courte durée, est faite pendant la période de recuit à la température T1 et commence à un instant t7 suivant la période t5-t6 de dépôt de germanium, pour se terminer à un instant t8. La deuxième étape d'épitaxie E2 est faite de façon classique à la température T2, entre des instants t3' et t4'.

Selon l'invention, la durée t7-t8, la durée t8-t3' et l'épaisseur de la couche épitaxiée formée entre les instants t7 et t8 sont telles que l'épaisseur de la première couche épitaxiée est supérieure à la longueur de diffusion de l'arsenic ou du phosphore pendant la durée t7-t3'. On définit ici la longueur de diffusion de l'arsenic ou du phosphore comme la distance moyenne que parcourent des atomes d'arsenic ou de phosphore dans l'épaisseur d'une couche épitaxiée pendant une durée donnée représentative du procédé, dans des conditions de température et de pression données.

Ainsi, selon cet aspect de l'invention, la couche de silicium épitaxiée entre les instants t7 et t8 est une couche de confinement, ou barrière d'isolement, s'opposant à la diffusion des atomes résiduels d'arsenic ou de phosphore dans la deuxième couche de silicium, épitaxiée entre les instants t3' et t4'.

A titre d'exemple, la durée de dépôt entre les instants t7 et t8 peut être de 15 secondes et la durée d'attente entre les instants t8 et t3' de l'ordre de 30 secondes. Dans ce cas, la longueur de diffusion de l'arsenic entre les instants t7 et t3' est typiquement de l'ordre de 40 nm, de sorte que l'épaisseur de la première couche de silicium épitaxiée est choisie de l'ordre de 50 à 60 nm. La durée t3'-t4' de dépôt de la deuxième couche de silicium épitaxiée, supérieure à la minute, est fonction de l'épaisseur totale de la couche épitaxiée à faire croître. Enfin, les durées t5-t6 de dépôt de germanium et t6-t7 d'élimination partielle des atomes superficiels d'arsenic ou de phosphore sont choisies comme indiqué plus haut, et sont par exemple de 15 et 30 secondes.

Le procédé en deux temps selon l'invention permet de réduire considérablement l'autodopage dû aux atomes d'arsenic ou de phosphore résiduels n'ayant pas été éliminés par le balayage d'hydrogène entre les instants t6 et t7. Pour fixer les idées sur les résultats très avantageux qu'offre une telle combinaison de moyens, on a représenté en figure 6 la courbe 15-3 de la conductivité d'une couche de silicium épitaxiée en deux temps avec interposition de germanium sur une plaquette de test du type déjà décrit (figure 5), comportant des régions 11 dopées à l'arsenic. On constate que l'autodopage par l'arsenic est pratiquement supprimé, l'augmentation de la conductivité au dessus de la zone implantée de la plaquette de test étant très faible et quasiment négligeable au regard de la courbe 15-1 de l'art antérieur.

Comme précédemment, des mesures similaires avec une implantation au phosphore d'une plaquette de test ont donné des avantages équivalents alors que des mesures avec une implantation au bore n'ont pas montré de différence avec l'art antérieur. Ainsi, ici également, on voit que la présente invention permet de diminuer l'autodopage par l'arsenic ou le phosphore sans augmenter l'autodopage par le bore.

Bien entendu, les deux aspects de l'invention qui viennent d'être combinés peuvent être mis en oeuvre chacun indépendamment de l'autre. Toutefois, la combinaison de procédés qui vient d'être décrite apparaît, en l'état actuel des connaissances de la demanderesse, comme la solution la plus avantageuse pour la suppression quasi totale de l'autodopage par l'arsenic ou le phosphore, ou l'obtention du compromis le plus avantageux entre l'autodopage par l'arsenic ou le phosphore, d'une part, et l'autodopage par le bore, d'autre part.

Par ailleurs, il va de soi que les variantes décrites plus haut en ce qui concerne le dépôt de germanium et le choix des paramètres de travail dans le réacteur d'épitaxie sont applicables par analogie à ce mode de réalisation de l'invention. Notamment, selon une variante, le dépôt de germanium est effectué entre les instants t7 et t8, c'est-à-dire simultanément au dépôt de la première couche de silicium épitaxiée. On réalise ainsi un alliage SiGe de faible épaisseur ayant à la fois pour fonction de créer des sites atomiques favorisant l'élimination des atomes superficiels d'arsenic ou de phosphore, et de s'opposer à la diffusion des atomes résiduels dans la couche épitaxiée entre les instants t3' et t4'. Selon une autre variante, un dépôt complémentaire de germanium est réalisé entre les instants t8 et t2. Selon encore une autre variante, un seul dépôt de germanium est réalisé entre les deux périodes de croissance épitaxiale, de préférence entre les instants t8 et t2.

Enfin, il est avantageux de prévoir un dopage volontaire de type N de la couche épitaxiée entre les instants t7 et t8, de manière que le dopage final de la couche épitaxiale soit parfaitement contrôlé et ne varie pas d'un circuit à l'autre en fonction de la géométrie et du dopage des couches enterrées. Le dopage volontaire est bien entendu réalisé avec une concentration de dopant supérieure à la concentration de dopant due à l'autodopage. A cet effet, on peut par exemple augmenter la pression partielle de phosphine et/ou d'arsine entre les instants t7 et t8. Egalement, une atmosphère d'arsine peut être prévue entre les instants t2 et t3', peu avant l'instant t3'. On peut noter que cet aspect de l'invention n'est avantageux qu'en raison de la forte diminution du phénomène d'autodopage grâce à la présente invention, conférant une marge de manoeuvre pour le contrôle du dopage final. Cet aspect de l'invention est particulièrement destiné aux cas où l'autodopage à l'arsenic ou au phosphore n'est pas entièrement supprimé en raison d'un compromis visant à diminuer l'autodopage au bore, et est par ailleurs applicable au procédé d'épitaxie en une seule étape décrit en relation avec la figure 4.

En définitive, il ressort clairement de ce qui précède que la présente invention permet avantageusement de maîtriser le phénomène d'autodopage des couches épitaxiées, y compris l'autodopage au bore, de diminuer les températures de travail dans les réacteurs d'épitaxie, et permet de façon générale d'augmenter les rendements de fabrication et le coût de revient des circuits intégrés.

## Revendications

1. Procédé de dépôt par croissance épitaxiale en phase gazeuse d'une couche de silicium (4) sur un substrat de silicium monocristallin (1) comprenant des zones comportant un dopage de type N+ d'arsenic ou de phosphore (2), tout en limitant l'autodopage par l'arsenic ou le phosphore de la couche de silicium épitaxiée (4), **caractérisé en ce qu'**il comprend :
a-une étape (t5-t6, t7-t8) de dépôt de germanium de l'ordre de la fraction de monocouche atomique à quelques couches atomiques à la surface du substrat de silicium, le dépôt étant réalisé en phase gazeuse en présence d'hydrogène, suivie
b- d'une étape de désorption (t6-t2, t6-t7) par recuit d'atomes d'arsenic ou de phosphore présents à la surface du substrat.

2. Procédé selon la revendication 1, **caractérisé en ce que** l'étape de croissance épitaxiale de la couche de silicium est réalisée postérieurement à une phase préliminaire de recuit effectuée en présence d'hydrogène et à basse pression à une température de recuit supérieure à la température de croissance épitaxiale de la couche de silicium.

3. Procédé selon la revendication 2, **caractérisé en ce que** les étapes a- et b- sont réalisées successivement au cours de la phase préliminaire de recuit.

4. Procédé selon la revendication 2, **caractérisé en ce que** l'étape a- est effectuée au commencement (t3) de l'étape de croissance épitaxiale de la couche de silicium (t3-t4) en introduisant un composé gazeux du germanium en présence d'hydrogène dans la phase gazeuse d'épitaxie de sorte à obtenir un alliage silicium-germanium formant une couche de base de la couche de silicium épitaxiée.

5. procédé selon la revendication 1, **caractérisé en ce que** la croissance épitaxiale de la couche de silicium est décomposée en deux parties consistant en une première étape (E1, t7-t8) de dépôt d'une couche mince de silicium réalisée au cours d'une phase préliminaire de recuit et en une seconde étape (E2, t3'-t4') de dépôt d'une couche complémentaire de silicium permettant d'obtenir l'épaisseur recherchée de la couche de silicium épitaxiée, ladite phase préliminaire de recuit étant effectuée à une température de recuit supérieure à la température de dépôt de ladite couche complémentaire de silicium.

6. procédé selon la revendication 5, **caractérisé en ce que** les conditions et la durée de la première étape (E1, t7-t8) sont choisies de sorte que la couche mince a une épaisseur supérieure à la longueur de diffusion des atomes d'arsenic ou de phosphore, afin de former une couche de confinement ou une barrière d'isolement s'opposant à la diffusion des atomes d'arsenic ou de phosphore dans la couche complémentaire de silicium.

7. Procédé selon la revendication 5 ou 6, **caractérisé en ce que** les étapes a- et b- sont réalisées successivement au cours de la phase préliminaire de recuit préalablement au dépôt de la couche mince de silicium.

8. Procédé selon la revendication 5 ou 6, **caractérisé en ce que** l'étape a- est effectuée simultanément au dépôt par croissance épitaxiale de la couche mince de silicium (t7-t8), en introduisant un composé gazeux du germanium en présence d'hydrogène dans la phase gazeuse d'épitaxie pour former un alliage silicium-germanium.

9. Procédé selon la revendication 5 ou 6, **caractérisé en ce que** les étapes a- et b- sont effectuées entre la première étape (E1, t7-t8) et la seconde étape (E2, t3'-t4') de la croissance épitaxiale de la couche de silicium, au cours de la phase préliminaire de recuit.

10. Procédé selon la revendication 4 ou 8, **caractérisé en ce que** l'étape de croissance épitaxiale du silicium (t3-t4, t7-t8) est effectuée avec une vitesse de croissance afin de permettre la désorption concomitante des atomes superficiels d'arsenic ou de phosphore.

11. Procédé selon l'une quelconque des revendications 3, 7 ou 9, **caractérisé en ce que** l'étape de désorption des atomes superficiels d'arsenic ou de phosphore est réalisée sous vide par pompage et/ou sous l'action d'un balayage de la surface du substrat par un gaz d'hydrogène.

12. Procédé selon l'une quelconque des revendications 1 à 11, **caractérisé en ce que** le débit de gaz d'hydrogène est augmenté au moins pendant une période d'exposition du germanium au gaz hydrogène, afin de favoriser l'élimination des atomes superficiels d'arsenic ou de phosphore.

13. Procédé selon l'une quelconque des revendications 1 à 12 **caractérisé en ce que** la présence d'hydrogène est maintenue à basse pression.

14. Procédé selon l'une quelconque des revendications1 à 13, **caractérisé en ce que** un composé dopant de type N est introduit dans la phase gazeuse d'épitaxie pour obtenir un dopage volontaire de la couche de silicium épitaxiée (E1, t7-t8; t3-t4) supérieur à la valeur d'autodopage.

## Patentansprüche

1. Verfahren zur Ablagerung einer Siliziumschicht (4) auf einem monokristallinen Siliziumsubstrat (1), das Zonen mit einer N+ Dotierung mit Arsen oder Phosphor (2) aufweist, durch epitaktisches Wachstum in der Gasphase bei gleichzeitiger Begrenzung der Autodotierung der epitaktischen Siliziumschicht (4) durch Arsen oder Phosphor, **dadurch gekennzeichnet, daß** es aufweist:
a- einen Schritt (t5-t6, t7-t8) einer Ablagerung von Germanium in der Größenordnung von dem Bruchteil einer atomaren Monoschicht bis zu einigen atomaren Schichten an der Oberfläche des Siliziumsubstrates, wobei die Ablagerung in der Gasphase in Gegenwart von Wasserstoff realisiert wird, gefolgt von
b- einem Desorptionsschritt (t6-t2, t6-t7) durch Wiedererwärmen von Arsen- oder Phosphoratomen, die sich an der Oberfläche des Substrats befinden.

2. Verfahren nach Anspruch 1, **dadurch gekennzeichnet, daß** der Schritt des epitaktischen Wachstums der Siliziumschicht nach einer vorhergehenden Wiedererwärmungsphase in Gegenwart von Wasserstoff und bei niedrigem Druck bei einer Wiedererwärmungstemperatur bewirkt wird, die höher ist als die Temperatur für das epitaktische Wachstum der Siliziumschicht.

3. Verfahren nach Anspruch 2, **dadurch gekennzeichnet, daß** die Schritte a- und b- nacheinander im Verlauf der vorhergehenden Wiedererwärmungsphase realisiert werden.

4. Verfahren nach Anspruch 2, **dadurch gekennzeichnet, daß** der Schritt a- am Beginn (t3) des Schrittes des epitaktischen Wachstums der Siliziumschicht (t3-t4) ausgeführt wird, wobei eine gasförmige Verbindung von Germanium in Gegenwart von Wasserstoff in der Gasphase der Epitaxie zugeführt wird, um eine Silizium-Germaniumverbindung zu erhalten, die eine Basisschicht der epitaktisch gewachsenen Siliziumschicht bildet.

5. Verfahren nach Anspruch 1, **dadurch gekennzeichnet, daß** das epitaktische Wachstum der Siliziumschicht in zwei Teile zerlegt ist, die aus einem ersten Schritt (E1, t7-t8) einer Ablagerung einer dünnen Siliziumschicht, die im Verlauf einer vorhergehenden Wiedererwärumgsphase realisiert wird, und einem zweiten Schritt (E2, t3'-t4') einer Ablagerung einer komplementären Siliziumschicht bestehen, wobei es ermöglicht wird, die gewünschte Dicke der epitaktisch gewachsenen Siliziumschicht zu erhalten, wobei die vorhergehende Wiedererwärmungsphase bei einer Wiedererwärmungstemperatur bewirkt wird, die höher ist als die Ablagerungstemperatur der komplementären Siliziumschicht.

6. Verfahren nach Anspruch 5, **dadurch gekennzeichnet, daß** die Bedingungen und die Dauer des ersten Schrittes (E1, t7-t8) derart gewählt sind, daß die dünne Schicht eine Dicke aufweist, die größer ist als die Diffusionslänge der Arsen- oder Phosphoratome, um eine Begrenzungsschicht oder eine Isolationsbarriere zu bilden, die sich der Diffusion der Arsen- oder Phosphoratome in der komplementären Siliziumschicht widersetzt.

7. Verfahren nach Anspruch 5 oder 6, **dadurch gekennzeichnet, daß** die Schritte a- und b-sukzessive im Verlauf der vorhergehenden Wiedererwärmungsphase vor der Ablagerung der dünnen Siliziumschicht realisiert werden.

8. Verfahren nach Anspruch 5 oder 6, **dadurch gekennzeichnet, daß** der Schritt a- gleichzeitig mit der Ablagerung durch epitaktisches Wachstum der dünnen Siliziumschicht (t7-t8) ausgeführt wird, wobei eine gasförmige Verbindung von Germanium in Gegenwart von Wasserstoff in der Gasphase der Epitaxie zugeführt wird, um eine Silizium-Germaniumverbindung zu bilden.

9. Verfahren nach Anspruch 5 oder 6, **dadurch gekennzeichnet, daß** die Schritte a- und b-zwischen dem ersten Schritt (E1, T7-t8) und dem zweiten Schritt (E2, t3'-t4') des epitaktischen Wachstums der Siliziumschicht im Verlauf der vorhergehenden Wiedererwärmungsphase ausgeführt werden.

10. Verfahren nach Anspruch 4 oder 8, **dadurch gekennzeichnet, daß** der Schritt des epitaktischen Wachstums des Siliziums (t3-t4, t7-t8) mit einer Wachstumsgeschwindigkeit ausgeführt wird, um die gleichzeitige Desorption der Arsen- oder Phosphoroberflächenatome zu ermöglichen.

11. Verfahren nach irgendeinem der Ansprüche 3, 7 oder 9, **dadurch gekennzeichnet, daß** der Schritt einer Desorption der Arsen- oder Phosphoroberflächenatome unter Vakuum durch Pumpen und/oder unter der Wirkung einer Spülung der Oberfläche des Substrates mit einem Wasserstoffgas realisiert wird.

12. Verfahren nach irgendeinem der Ansprüche 1 bis 11, **dadurch gekennzeichnet, daß** der Durchsatz von Wasserstoffgas zumindest während einer Periode eines Aussetzens des Germaniums gegen Wasserstoffgas erhöht wird, um die Beseitigung von Arsen- oder Phosphoroberflächenatomen zu begünstigen.

13. Verfahren nach irgendeinem der Ansprüche 1 bis 12, **dadurch gekennzeichnet, daß** die Gegenwart von Wasserstoff bei niedrigem Druck aufrechterhalten wird.

14. Verfahren nach irgendeinem der Ansprüche 1 bis 13, **dadurch gekennzeichnet, daß** eine dotierende Verbindung des Typs N in die Gasphase der Epitaxie zugeführt wird, um eine beabsichtigte Dotierung der epitaktisch gewachsenen Siliziumschicht zu erhalten (D1, t7-t8; t3-t4), die höher ist als der Wert der Autodotierung.

## Claims

1. Method of deposition, by epitaxial growth in the gas phase, of a layer of silicon (4) on a substrate of single-crystal silicon (1) comprising zones having N+ type doping with arsenic or phosphorus (2), while limiting autodoping with arsenic or phosphorus of the epitaxial silicon layer (4), **characterised in that** it comprises:
a) a step (t5-t6, t7-t8) of deposition of germanium of the order of the fraction of atomic monolayer with a few atomic layers on the surface of the silicon substrate, deposition taking place in the gas phase in the presence of hydrogen, followed by
b) a step of desorption (t6-t2, t6-t7) by annealing arsenic or phosphorus atoms present on the surface of the substrate.

2. Method according to Claim 1, **characterised in that** the step of epitaxial growth of the layer of silicon is performed after a preliminary annealing phase carried out in the presence of hydrogen and at low pressure, at an annealing temperature higher than the temperature of epitaxial growth of the layer of silicon

3. Method according to Claim 1, **characterised in that** steps a) and b) are performed in succession during the preliminary annealing phase.

4. Method according to Claim 2, **characterised in that** step a) is carried out at the beginning (t3) of the step of epitaxial growth of the layer of silicon (t3-t4) by introducing a gaseous compound of germanium in the presence of hydrogen into the epitaxy gas phase so as to obtain a silicon-germanium alloy forming a base layer for the epitaxial silicon layer.

5. Method according to Claim 1, **characterised in that** the epitaxial growth of the layer of silicon is divided into two parts consisting of a first step (E1, t7-t8) of deposition of a thin layer of silicon carried out in a preliminary annealing phase and of a second step (E2, t3' -t4') of deposition of an additional layer of silicon making it possible to obtain the required thickness of the epitaxial silicon layer, said preliminary annealing phase being carried out at an annealing temperature above the temperature of deposition of said additional layer of silicon.

6. Method according to Claim 5, **characterised in that** the conditions and duration of the first step (E1, t7-t8) are selected so that the thin layer has a thickness greater than the diffusion length of the arsenic or phosphorus atoms, in order to form a confinement layer or an insulation barrier opposed to the diffusion of the arsenic or phosphorus atoms into the additional layer of silicon.

7. Method according to Claim 5 or 6, **characterised in that** steps a) and b) are carried out in succession during the preliminary annealing phase before the deposition of the thin layer of silicon.

8. Method according to Claim 5 or 6, **characterised in that** step a) is carried out at the same time as the deposition by epitaxial growth of the thin layer of silicon (t3-t4), by introducing a gaseous compound of germanium in the presence of hydrogen into the epitaxy gas phase in order to form a silicon-germanium alloy.

9. Method according to Claim 5 or 6, **characterised in that** steps a) and b) are carried out between the first step (E1, t7-t8) and the second step (E2, t3'-t4') of the epitaxial growth of the layer of silicon during the preliminary annealing phase.

10. Method according to Claim 4 or 8, **characterised in that** the step of epitaxial growth of silicon (t3-t4, t7-t8) is carried out at a growth rate so as to allow the concomitant desorption of the surface atoms of arsenic or phosphorus.

11. Method according to any one of Claims 3, 7 or 9, **characterised in that** the step of desorption of the surface atoms of arsenic or phosphorus is performed in a vacuum by pumping and/or under the action of sweeping the substrate surface by a hydrogen gas.

12. Method according to any one of Claims 1 to 11, **characterised in that** the output of hydrogen gas is increased at least over a period when the germanium is exposed to hydrogen gas, so as to encourage the elimination of the surface atoms of arsenic or phosphorus.

13. Method according to any one of Claims 1 to 12, **characterised in that** the presence of hydrogen is kept at low pressure.

14. Method according to any one of Claims 1 to 13, **characterised in that** an N-type doping compound is introduced into the epitaxy gas phase in order to produce intentional doping of the layer of silicon subjected to epitaxy (E1, t7-t8, T3-t4) greater than the autodoping value.
